# EUROPEAN PATENT SPECIFICATION

(11) **EP 0 730 300 B1**
(45) Date of publication and mention of the grant of the patent: **02.01.2002**
(21) Application number: 95830067.5
(22) Date of filing: 28.02.1995
(51) Int. Cl.: H01L 27/02

(54) **Device for the protection of an integrated circuit against electrostatic discharges**
Bauelement zum Schutz einer integrierten Schaltung gegen elektrostatische Entladungen
Dispositif pour la protection d'un circuit intégré contre des décharges électrostatiques

(43) Date of publication of application: 04.09.1996
(73) Proprietor: STMicroelectronics S.r.l., 20041 Agrate Brianza (Milano) (IT)
(72) Inventor: Ravanelli, Enrico M. A., I-20052 Monza (MI) (IT); Martignoni, Fabrizio, I-21040 Morazzone (VA) (IT)
(74) Representative: Botti, Mario

(56) References cited:
- EP-A- 0 532 481
- US-A- 4 811 155
- PATENT ABSTRACTS OF JAPAN vol. 017 no. 504 (E-1430) ,10 September 1993 & JP-A-05 129530 (TOSHIBA CORP) 25 May 1993,
- PATENT ABSTRACTS OF JAPAN vol. 014 no. 557 (E-1011) ,11 December 1990 & JP-A-02 240959 (TOSHIBA CORP;OTHERS: 01) 25 September 1990,

## Description

This invention relates to devices for protecting integrated circuits against electrostatic discharges, and in particular to a compact-size protector for integrated circuits using mixed type technologies and being operated on low supply voltages.

It is a recognized fact that the contact pads of an integrated circuit are liable to incidentally come in contact with electrically charged objects, both during their manufacture and during their assembly to circuitry, or while in operation. As a result, sufficient potential differences can be developed between areas or parts of the integrated circuit to damage or even destroy thin dielectrics provided in the device, such as the gate oxides of transistors of the MOS type.

Thus, as the potential difference caused by an electrostatic situation exceeds the dielectric strength of the gate isolation, a MOS transistor is made unserviceable by the electrostatic discharge which occurs through the isolation.

This is a destructive effect that, in a circuit integrated by a technology of the MOS type providing for a minimum gate dimension of 1.2 µm, for example, may already take place at a voltage as low as about 12 V, that is, at much lower values than those brought about by electrostatic discharges in some cases.

Known are several measures for protecting the input and output terminals of an integrated circuit from electrostatic discharges whose effectiveness is obviously tied to the integration characteristics.

Some of these measures provide for the use of serially connected resistors and serially or parallel connected diodes, integrated to the substrate of the integrated circuit, for limiting or "suppressing" the currents due the electric discharges, and are effective basically to protect the input-terminals.

The EP application No. 92830477.3 (EP-A-0 532 481) discloses an integrated protective structure which provides protection from electrostatic discharges of structures to an integrated circuit functionally connected to a certain external pin. The protective structure is formed in a single epitaxial tub and includes a triggering Zener diode and a vertical bipolar transistor.

Other, more elaborate measures provide for the use of thyristor structures or SCRs (Silicon Controlled Rectifiers) and can be employed to protect both the input and output terminals, with possible modifications to keep the firing voltage low.

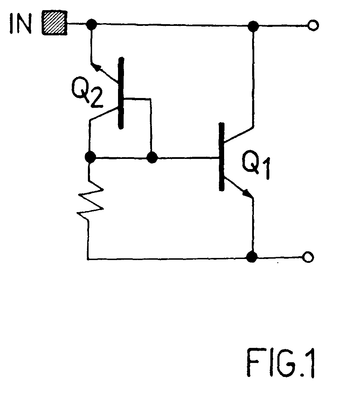

Figure 1 of the drawings attached to this specification shows an input protection circuit for circuits of the BiCMOS type, i.e. with technologies of mixed types.

The transistors Q1 and Q2 jointly form an equivalent structure of a Zener diode connected between the input terminal IN and the ground of the integrated circuit GND. This type of ESD (Electrostatic Discharge) protector and its operation are described, for instance, in a book "BiCMOS Technology and Applications", Second Edition, edited by A.R. Alvarez (Cypress Semiconductor Corporation).

That protector is quite a compact one, and readily integratable by a process of the BiCMOS type, which is highly beneficial where a protector is provided for each terminal of the integrated circuit which may come in contact with external objects.

However, it is not compatible with terminals that, in operation, may be subjected to a possibly negative dynamic range.

The underlying technical problem of this invention is to provide a protector against electrostatic discharges which is uniquely compact and fast, readily integratable even by processes of the BiCMOS type, and can be used to protect both the input and output terminals (including the power supply terminals) under any conditions of operation.

This problem is solved by a protector and defined in the characterizing parts of the appended claim to this specification.

The features and advantages of a protector according to the invention will be apparent from the following description of an embodiment thereof, given by way of example and not of limitation with reference to the accompanying drawings.

In the drawings:
Figure 1 shows a circuit diagram for a conventional protector as previously mentioned;
Figure 2 shows a circuit diagram for a protector that can be made according to the invention; and
Figure 3 is a sectional view of a viable protector structure according to the invention.

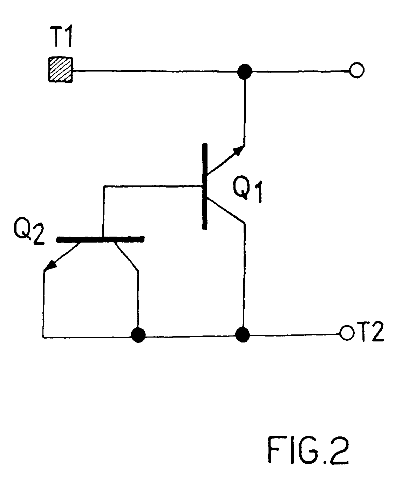

The electrostatic discharge protection circuit shown in Figure 2 is quite simple, and comprises first Q1 and second Q2 transistors, both of the bipolar NPN type in the preferred embodiment.

The transistor Q1 is connected between a terminal T1 to be protected and, preferably, the ground T2 of the integrated circuit incorporating the protector (or protectors, if several terminals of the integrated circuit are to be protected against electrostatic discharges) with its emitter terminal and collector terminal, respectively.

The transistor Q2 is connected to the collector terminal of the transistor Q1 with both its emitter and collector terminals, and hence to the ground T2 in this case.

The transistors Q1 and Q2 have their respective base terminals connected together.

It is always safer to have the protector connected between the terminal requiring protection and a ground connection, even where the power supply terminals are involved. Thus, in the present instance, it is better to use two protectors, one for each of the two power supply terminals, although an amount of protection could be provided by a single device connected between the two terminals.

During a positive discharge, the emitter-to-base junction of the transistor Q1 would be the subject of avalanche conduction, the transistor Q2 diode-biased, and the base-to-collector junction of the transistor Q1 operated in forward conduction.

Accordingly, the transistor Q1 works inversely in a BVcer mode of operation, and exhibits a very low output impedance.

During a negative discharge, on the other hand, it would be the emitter-to-base junction of the transistor Q2 to become the subject of avalanche conduction, so that the transistor Q1 is supplied a base current and begins to operate in the active range.

Once turned on, the transistor Q1 draws most of the current, and the series resistance of the structure is quite small.

If the transistors Q1 and Q2 are identical, the breakdown voltage of the structure is "symmetrical" for positive and negative electrostatic discharges.

In either case, the breakdown voltage will be dependent on the choice of the two transistors Q1 and Q2.

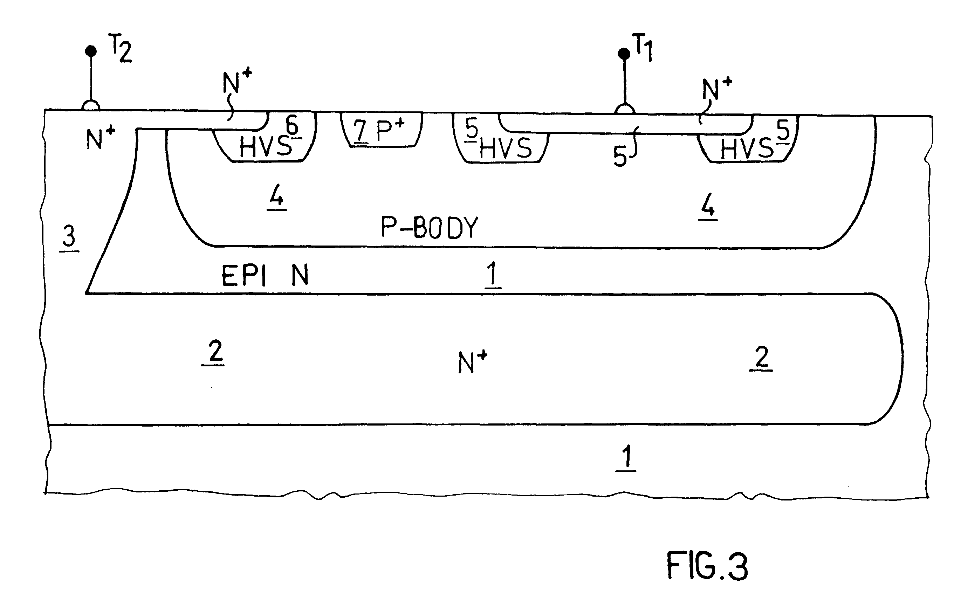

Figure 3 is a sectional view of a viable protector structure according to the invention, which may be implemented, but not solely so, by a mixed type technology.

This structure can be formed on a monocrystalline silicon slice comprising a substrate doped with impurities of the P type and overlaid by an epitaxial layer 1 which is doped with impurities of the N type, the epitaxial layer having a thickness of 8 to 10 µm and resistivity in the 1.5 Ohm*cm range.

In growing the epitaxial layer 1, by techniques which are well known to the skilled ones in the art, a buried area or layer 2 is formed which is more heavily doped (N⁺) than the remainder of the layer and connected to the surface by a sinker region 3, also of the N⁺ type.

Formed on the epitaxial layer 1, over the buried layer 2, is a P-type or P-body surface region 4, in the present instance by boron implantation at a dosage in the range of 1*10¹³ cm⁻² to 3*10¹³ cm⁻², to a depth of about 1.25 µm.

A region 5 of the N⁺ type, extending into the P-body region from its surface, is formed by arsenic implantation at a dosage in the 1*10¹⁵ cm⁻² range and to a depth of about 0.3 µm.

In addition, a surface region 6 is similarly formed which extends from the sinker region 3 to an edge area of the P-body region.

Suitable means of electric connection, illustrated by leads T1 and T2 in the drawings for simplicity, but actually comprised in part of diffused regions of the N⁺ type and in part of paths of an electrically conductive material, such as aluminum or doped polycrystalline silicon, are formed on the regions 5 and 3 in ohmic contact therewith.

Thus, the protective circuit structure depicted in Figure 2 has been implemented in a very simple way.

The transistor Q1 connected between the terminal T1 to be protected and a ground T2 consists of the NPN succession of the regions 5, 4 and 2, wherein the region 5 is the emitter, the P-body region is the base, and the epitaxial layer provides, specifically by its buried area 2, the collector.

This applies to the transistor Q2 as well, whose emitter is the region 6 overlying the peripheral area of the common P-body base region, while the common collector is provided by the region 2, being connected to the emitter region 6 through the sinker region 3.

According to the invention, HVS (High Voltage Shift) diffusions are provided at the edges of the emitter regions 5 and 6 which have a lower dopant concentration than the core portion, in order to increase the radius of curvature of the junction edge and, therefore, better control its breakdown by avoiding the formation of destructive "hot spots".

Interposed between the two emitter regions 5 and 6 is an area 7 of the P type which has a higher dopant concentration than the other areas of the P-body region, for the purpose of providing enhanced isolation of the two emitter regions 5 and 6 from each other.

It will be appreciated that changes, integrations and substitutions of elements may be made unto the embodiment illustratively discussed hereinabove, without departing from the protection scope of the following claims.

## Claims

1. A protector device against electrostatic discharges monolithically integrated in a first conductivity type (N) semiconductor material substrate (1) comprising a first region (4) with a second type of conductivity (P) being the opposite of the first conductivity type, said first region extending into the substrate from a surface thereof and surrounding at least a first conductivity type (N+) second region (5) extending in said first region from said surface, said device comprising at least a third region (3) having the first type (N+) of conductivity and extending from said surface into an area of the substrate and a first peripheral area of the first region (4) **characterized in that** the second region (5) comprises a second peripheral portion (HVS, 5) which surrounds a core portion, the said core portion having at least one area where it extends into the first region (4) less deeply than in the second peripheral portion, said second peripheral portion (HVS) being doped with impurities at a lower concentration than in said at least one area, third region (3) comprising a third peripheral portion (HVS, 6) which extends into the first region deeper than a non-peripheral portion of said third region being doped with impurities at a higher concentration than in the third peripheral portion.

## Patentansprüche

1. Schutzvorrichtung gegen elektrostatische Entladungen für einen Schaltkreis, der monolithisch in ein Substrat (1) aus halbleitfähigem Material integriert ist, mit einem ersten Leitfähigkeitstyp (N), der einen ersten Bereich (4) umfaßt, mit einem zweiten Leitfähigkeitstyp (P), der dem ersten Leitfähigkeitstyp entgegengesetzt ist, wobei sich der besagte erste Bereich in das Substrat erstreckt, ausgehend von einer seiner Flächen und zumindest einen zweiten Bereich (5) umgibt, der die Leitfähigkeit des ersten Typs (N+) aufweist und sich, ausgehend von der besagten Oberfläche, in den besagten ersten Bereich erstreckt; die besagte Vorrichtung umfaßt zumindest einen dritten Bereich (3) mit einer Leitfähigkeit des ersten Typs (N+), wobei sich dieser Bereich, ausgehend von der besagten Oberfläche, in eine Zone des Substrats und in eine erste periphere Zone des ersten Bereichs (4) erstreckt, **dadurch gekennzeichnet, daß** der zweite Bereich (5) eine zweite periphere Zone (HVS,5) besitzt, die einen mittleren Teil umgibt, wobei dieser mittlere Teil zumindest eine Zone besitzt, in die dieser sich in dem ersten Bereich (4) weniger tief erstreckt als der zweite periphere Teil, wobei der besagte zweite periphere Teil (HVS) durch Verunreinigungen dotiert ist, deren Konzentration geringer ist als jene in der besagten zumindesten einer Zone, während der dritte Bereich (3) einen dritten peripheren Teil (HVS,6) umfaßt, der sich in den ersten Bereich tiefer als ein nicht-peripherer Teil des besagten dritten Bereichs erstreckt, der durch Verunreinigungen dotiert ist, deren Konzentration höher ist als jene in dem dritten peripheren Teil.

## Revendications

1. Dispositif de protection contre les décharges électriques pour un circuit monolithiquement intégré dans un substrat (1) de matériel sémiconducteur, ayant un premier type de conductibilité (N), comprenant une première région (4) ayant un deuxième type de conductibilité (P) opposé au premier type de conductibilité, ladite première région s'étendant dans le substrat à partir d'une de ses surfaces et entourant au moins une deuxième région (5), ayant une conductibilité du premier type (N+) s'étendant dans ladite première région à partir de ladite surface, ledit dispositif comprenant au moins une troisième région (3), ayant une conductibilité du premier type (N+) et s'étendant à partire de ladite surface dans une zone du substrat et dans une première zone périphérique de la première région (4), **caractérisé en ce que** la deuxième région (5) comprend une deuxième zone périphérique (HVS, 5) entourant une partie centrale, ladite partie centrale ayant au moins une zone s'étendant dans la première région (4) moins profondément par rapport à la deuxième partie périphérique, ladite deuxième partie périphérique (HVS) étant dopée par d'impuretés ayant une concentration inférieure à la concentration dans ladite au moins une zone, la troisième région (3) comprenant une troisième partie périphérique (HVS, 6) s'étendant dans la première région plus profondément par rapport à une partie non périphérique de ladite troisième région, qui est dopée avec d'impuretés ayant une concentration supérieure à la concentration dans la troisième partie périphérique.
